Europäisches Patentamt

European Patent Office

Office européen des brevets

(11) Publication number: **0 008 946**
**B1**

## EUROPEAN PATENT SPECIFICATION

(45) Date of publication of patent specification: **15.01.86**

(21) Application number: **79301831.8**

(22) Date of filing: **05.09.79**

(51) Int. Cl.⁴: **G 11 C 17/00, H 01 L 27/10,** **H 01 L 27/06**

(54) A semiconductor memory device.

(30) Priority: **08.09.78 JP 110503/78**

(43) Date of publication of application:
**19.03.80 Bulletin 80/06**

(45) Publication of the grant of the patent:
**15.01.86 Bulletin 86/03**

(84) Designated Contracting States:
**DE FR GB NL**

(56) References cited:
FR-A-2 334 170
FR-A-2 369 652
FR-A-2 378 331
GB-A-1 131 210
JP-A-53 068 182
US-A-3 510 689
US-A-3 533 088
US-A-3 576 549
US-A-3 721 964
US-A-3 742 592
US-A-3 792 319
US-A-3 909 805
US-A-3 979 734
US-A-4 006 470
US-A-4 014 007

(73) Proprietor: **FUJITSU LIMITED**
**1015, Kamikodanaka Nakahara-ku**
**Kawasaki-shi Kanagawa 211 (JP)**

(72) Inventor: **Fukushima, Toshitaka**
**1604-442, Shiomidai**
**Isogo-ku Yokohama-shi, Kanagawa 235 (JP)**

(74) Representative: **Rackham, Stephen Neil et al**
**GILL JENNINGS & EVERY 53-64 Chancery Lane**
**London WC2A 1HN (GB)**

(56) References cited:

IEEE PROCEEDINGS ON RELIABILITY PHYSICS,
2nd-4th April 1974, pages 74-81 Las Vegas,
U.S.A. D.E. BARNES et al.: "Reliability
Assessment of a Semi-conductor Memory by
Design Analysis"

IBM TECHNICAL DISCLOSURE BULLETIN, vol.
13, no. 5, October 1970 page 1191 Armonk,
U.S.A. F.H. DILL: "Insulator Breakdown Read-
Only Memory"

Courier Press, Leamington Spa, England.

(56) References cited:
IEEE INTERNATIONAL SOLID-STATE CIRCUITS CONFERENCE, vol. 20, no. 20 February 1977, pages 190-191 New York, U.S.A. J.E. SCHROEDER et al.: "A 1024-Bit, Fused-Link CMOS PROM", Digest of Technical Papers"

## Description

The present invention relates to a semiconductor memory and more particularly to a programmable read only memory used in an electronic device, such as an electronic computer.

In general, a programmable read only memory (P-ROM) consists of a matrix, which is formed by a cross structure of a plurality of bit lines and a plurality of word lines, with a memory cell at each crossing of lines of the matrix. Each memory cell consists of either two diodes of opposite polarity connected in series or of a fuse and a diode connected in series between the bit line and the word line. The write-in of information into this memory cell is carried out either by bringing one of the two diodes to a short-circuit status or by fusing the fuse. This is carried out by the supply of a write-in current to the appropriate bit and word lines. The value of this write-in current is, for example, between 100 mA and 200 mA, which is more than a hundred times greater than the read-out current, the typical value of which is about 0.5 mA.

In previous memories a decoder driver circuit is connected to one end of each word line. The write-in current flows through this decoder driver circuit. Thus, the decoder circuit has to be capable of handling the large write-in current. To meet this requirement, the decoder driver circuit comprises a large number of large, high current capacity transistors and similar elements and includes a great number of related connecting conductors. Thus, the decoder driver circuit is large in size and complicated in structure and it occupies a large area of the substrate and so reduces the number of memory cells that can be accommodated and the parasitic capacitance in the memory is increased, and thus its operating time is lengthened. Accordingly, it is desirable to increase the read-out speed of the memory to increase the information storing capacity or number of memory cells in a semiconductor device. The decoder driver circuit occupies its own space, which constitutes another problem in the prior art memory.

An example of a read only memory device of the combined diode type is shown in the United States Patent Specification No. 3742592, an example of a read only memory device of the fuse type is shown in the United States Patent Specification No. 3147461 and an introductory explanation regarding bipolar RAM and ROM is found in the Proceedings of Institute of Electronics and Communication Engineers of Japan Vol. 60, No. 11, November 1957, pages 1252 to 1257.

Another prior P-ROM type semiconductor memory is disclosed in FR—A—2334170 (Honeywell Bull) in which the memory cell consists of a lateral PNP type transistor and a PN junction diode or a fuse. This lateral PNP type transistor consists of an N type epitaxial layer which forms a word line and is formed on a P type semiconductor substrate with P type regions formed separately in the N type epitaxial regions. In this memory device, the write-in of the information is carried out by passing a write-in current from a selected bit line through the PN junction diode or fuse connected to the bit line, the lateral PNP type transistor, and a shunt which is parallel with the bit line. Accordingly, the write-in current to a memory cell located remote from the shunt passes through all the lateral PNP type transistors which are located between the memory cell and the shunt and are formed by P type regions forming the other memory cells.

Accordingly, in this memory device, the energy for writing-in the information into the selected memory cell differs in accordance with the bit line selected. Therefore, it is necessary to ensure that the write-in current is sufficiently large to enable write-in to the memory cells connected to the bit line located at the remotest position. Again this results in a reduction of the number of memory cells that it is possible to include on a single device partly due to the greater size of the cells to accommodate the larger currents that are necessary and partly by the provision of the shunt.

According to this invention as claimed a semiconductor memory comprises a P type semiconductor substrate, a word line including an N type layer having a portion contacting directly the P type substrate to form an NP junction and including an $N^+$ type region to reduce the resistance of the word line, a number of P type regions formed on the surface of the N type layer, N type regions formed in the P type regions, and a connecting conductor layer which is connected to the N type regions and which is used as a bit line the P type regions and the N type regions forming information storing elements, characterised in that the portion of the N type layer, contacting directly the P type substrate, is directly under the P type region, the P type substrate, the N type layer and the P type regions form vertical PNP type transistors, and the P type semiconductor substrate is used as a collector common to the vertical PNP type transistors having their emitters formed by the P type regions.

The flow of the write-in current into each memory cell takes place through the collector of the PNP type transistor, and thus reduces the current which flows in the decoder driver, and eliminates the necessity of increasing the current capacity of the decoder driver. Therefore the transistors and the like elements in the decoder driver may be made small, and their number reduced. Accordingly, this increases the read-out speed of the memory as well as increasing the degree of information storing capacity by enabling an increased number of memory cells in the semiconductor device.

FR—A—2369652 (Radiotechnique—Compelec) and JP—A—53-68182 (Fujitsu) both illustrate structures which, appear to be similar to the semiconductor memory in accordance with the present invention but, the structures disclosed in neither of the specifications provides an effective PNP type transistor through which the flow of write-in current into each memory cell takes place. In the French specification the $N^+$ layer traps most of the holes injected from the P type emitter region whereas in JP—A—53-68182 gold is diffused throughout the device to act as a lifetime killer and provide trap or recombination centres in the epitaxial layer. This again degrades the transistor effect of the PNP type layers.

US—A—3721964 illustrates the use of buried layers located along, but not under, a base stripe.

Particular examples of semiconductor memories in accordance with this invention and others developed during the development of the present invention will now be described with reference to the accompanying drawings; in which:—

Figures 1A and 1B are circuit diagrams of memories having their information storage devices formed by diodes;

Figures 2A, 2B and 2C are a plan, a longitudinal section along the line B—B and a cross-section along the line C—C, respectively, of an example of the prior art;

Figures 3A, 3B and 3C are a plan, a longitudinal section along the line B—B and a cross-section along the line C—C respectively, of a first example in accordance with this invention;

Figures 4A, 4B and 4C are a plan, a longitudinal section along the line B—B and a cross-section along the line C—C, respectively, of a second example in accordance with this invention;

Figures 5A, 5B and 5C are a plan, a longitudinal section along the line B—B and a cross-section along the line C—C, respectively, of a third example in accordance with this invention;

Figures 6A, 6B and 6C are a plan, a longitudinal section along the line B—B and a cross-section along the line C—C, respectively, of another example of the prior art; and,

Figure 7 shows a modification of the prior art example of Figures 2A, 2B, 2C.

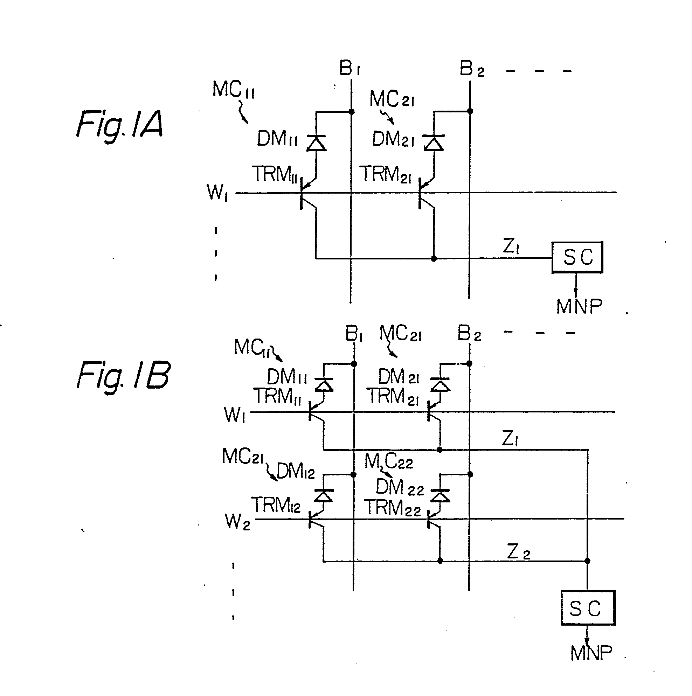

The circuit diagram of the memory, in accordance with the present invention, having the memory cell including the diode is illustrated in Figure 1A. A plurality of bit lines $B_1$, $B_2$ ... and plurality of word lines, one being $W_1$, ... are crossed to form a matrix. At each crossing point of the matrix the memory cells $MC_{11}$, $MC_{12}$, ... are connected between a bit line and a word line. The memory cell $MC_{11}$($MC_{21}$) consists of the series connected PN junction diode $DM_{11}$ ($DM_{12}$) as the information memorizing element and PNP type transistor $TRM_{11}$ ($TRM_{21}$). The diode $DM_{11}$ ($DM_{21}$) is connected between a bit line $B_1$ ($B_2$) and the emitter of the PNP type transistor $TRM_{11}$ ($TRM_{21}$). The bases of the PNP type transistors $TRM_{11}$, $TRM_{21}$, ... are connected to the word line $W_1$. The collectors of the PNP type transistors $TRM_{11}$, $TRM_{21}$ ... are connected to a common collector output line $Z_1$. The collector output line $A_1$ is connected to ground level potential or the most negative potential MNP through the current sink capacity circuit SC as the equivalent circuit formed by a portion of the PNP type transistors

$TRM_{11}$, $TRM_{21}$, ... The sink capacity circuit SC consists of a constant current source circuit.

In order to write-in information to, for example, the memory cell $MC_{11}$, the potential of the bit line $B_1$ is caused to become high and the potential of the word line $W_1$ is caused to become low. Thus the transistor $TRM_{11}$ is rendered at an ENABLE state and the potential of the emitter of the transistor $TRM_{11}$ is lowered. Accordingly, if the value of the voltage across the diode $DM_{11}$ is larger than the reverse blocking voltage of the diode $DM_{11}$, the PN junction of the diode $DM_{11}$ is broken down (short-circuited). This short-circuiting current for the diode $DM_{11}$ passes from the bit line $B_1$ through the diode $DM_{11}$ to the transistor $TRM_{11}$. The greater portion of said current passes from the emitter to the collector of the transistor $TRM_{11}$ and to the collector output line $Z_1$. The remaining portion of said current, which passes to the word line $W_1$, is $1/\beta$ of the collector current where $\beta$ is the common-emitter current gain and is less than the value of several milli-amperes. Thus, only the current of the value of several milli-amperes at the maximum passes through the word line $W_1$ even while writing-in, said value being similar to the value of the reading-out current. Accordingly, it is achieved that the greater portion of the current sink capacity for the information writing-in to the memory cell is constituted by the collector of the transistor $TRM_{11}$.

In the circuit illustrated in Figure 1B, which is a modification of the circuit shown in Figure 1A, the collector output lines $Z_1$ and $Z_2$, which are connected to the transistors $TRM_{11}$, $TRM_{21}$, ... and the transistors $TRM_{12}$, $TRM_{22}$, ..., connected to the word lines $W_1$, $W_2$ are connected together to the current sink capacity circuit SC as an equivalent circuit in the transistors which is connected to the most negative potential MNP. The operation of the circuit of Figure 1B will be easily understood with reference to the operation of the circuit of Figure 1A.

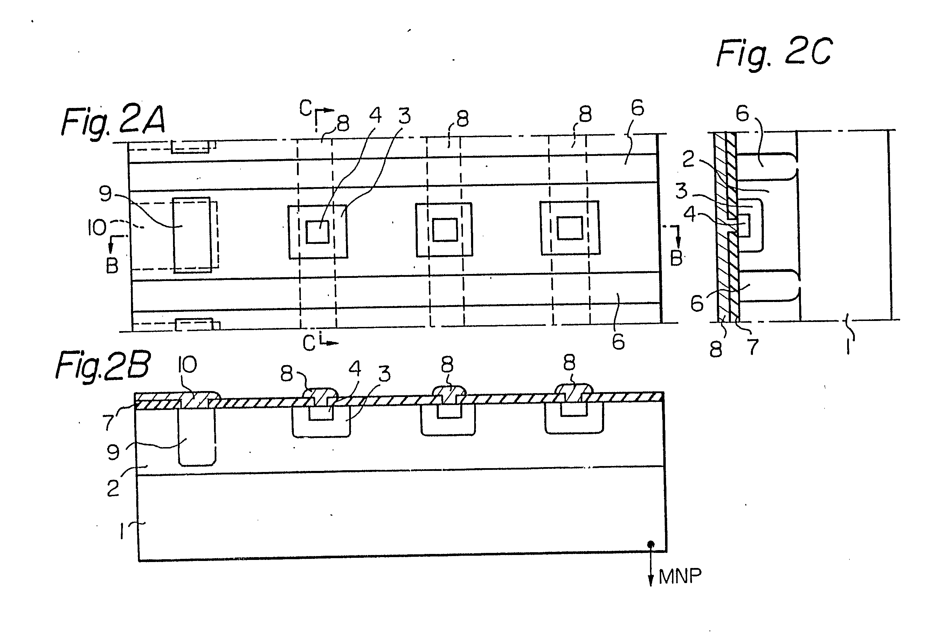

One prior art structure of the integrated circuit in which the memory circuit of Figure 1A is formed is illustrated in Figure 2A, 2B and 2C. This circuit is comparable to the circuits in FR—A—2369652. On the surface of the N type epitaxial layer 2 which is formed on the P type silicon semiconductor substrate 1, a plurality of P type regions 3 are formed separately, an $N^+$ type region 4 being formed in each of said P type regions 3.

The N type epitaxial layer 2 on the P type silicon semiconductor substrate 1 may be formed by means of the well known silicon epitaxial method. The P type regions 3 on the surface of the N type epitaxial layer 2 and the $N^+$ type regions 4 in the P type regions 3 may be formed by means of either the well known impurity diffusion method or the well known ion implantation method. Boron may be used as the impurity for forming the P type region. Phosphorus or arsenic may be used as the impurity for forming the N type region or layer.

The P type silicon semiconductor substrate 1 forms the common collector region of the PNP type transistor $TRM_{11}$, $TRM_{21}$, ... The N type epitaxial layer 2 forms the base region of the PNP type transistor $TRM_{11}$, $TRM_{12}$, ..., the common base region of the adjacent PNP type transistors, and at the same time the word line $W_1$ shown in Figure 1A. The P type region 3 forms the emitter region of the PNP type transistor $TRM_{11}$, $TRM_{21}$, ... The PN junction formed by the P type region 3 and the $N^+$ region 4 formed in the P type region 3 forms the diode $DM_{11}$ for storing the information shown in Figure 1A. The isolation region 6 which is formed in the N type epitaxial layer 2 extending from the surface of the N type epitaxial layer 2 to the P type silicon semiconductor substrate 1 isolates each word line from the adjacent word lines.

The surface of the epitaxial layer 2 including the memory cell is coated by an insulating layer 7 of, for example, silicon dioxide. A metal conductor bit line 8 of, for example aluminium is connected to the $N^+$ type region 4 forming a region of the diode DM through an aperture of the insulating layer 7. An $N^+$ type contact region 9 is formed in the N type epitaxial layer 2 and a metal conductor word line 10 of, for example, aluminium is connected to the $N^+$ type contact region 9 through an aperture of the insulating layer 7. The P type silicon semiconductor substrate 1 is connected to the most negative potential MNP. This substrate 1 corresponds to the current sink capacity circuit SC and plays a role of the collector output line $Z_1$ in Figure 1A.

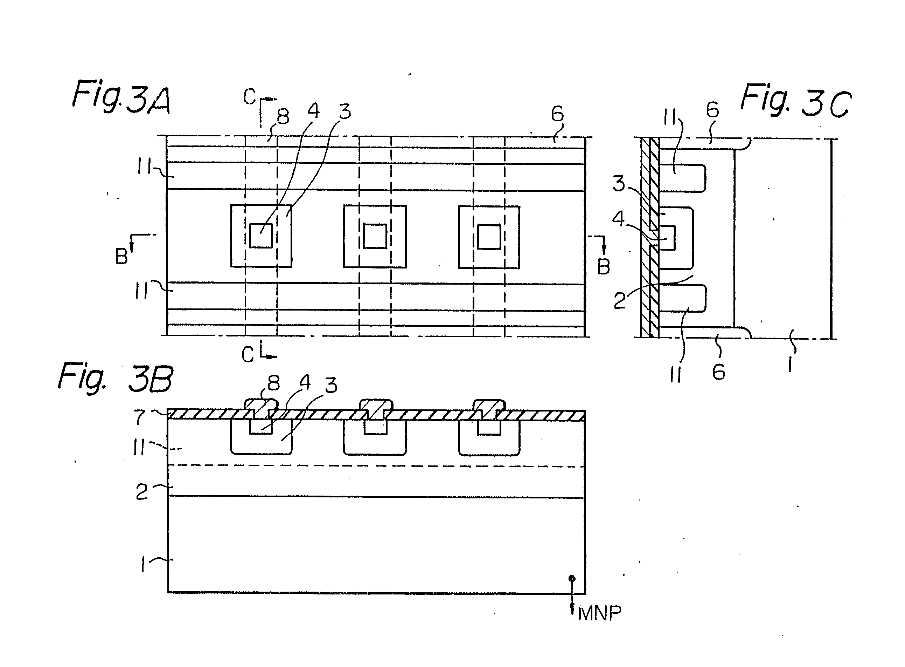

The device in accordance with this invention is a modification of the prior art structure shown in Figures 2A, 2B and 2C. In the first example, illustrated in Figures 3A, 3B, 3C, in accordance with this invention a $N^+$ type region 11 is formed on the surface of the N type epitaxial layer 2 in one side or both sides of the memory cell arrangement along the sequence of the memory cells. This $N^+$ type region 11 can also be formed simultaneously with the formation of the $N^+$ type region 4 or with the formation of the $N^+$ type region 9. This $N^+$ type region 11 plays a role to reduce the equivalent resistance of the N type epitaxial layer 2, which acts as a word line, along the longitudinal direction.

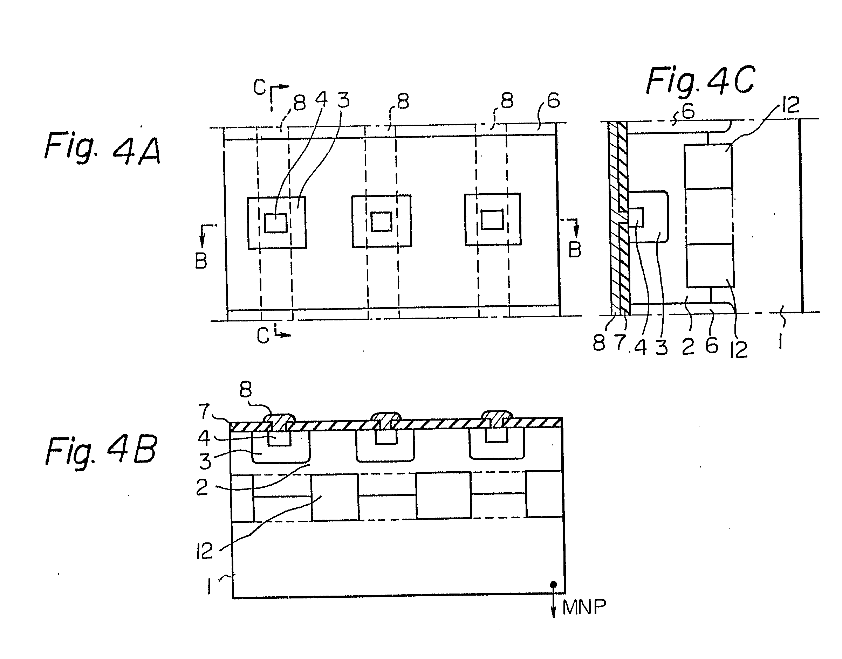

A second example of a device in accordance with this invention is shown in Figures 4A, 4B and 4C. In this example an $N^+$ type region 12, which corresponds to the $N^+$ type region 11 in the first example shown in Figures 3A, 3B and 3C, is formed in the border between the N type epitaxial layer 2 and the P type silicon semiconductor substrate 1. The $N^+$ type region 12 has its width extending to the vicinity of each of the two side isolation regions 6 and has its length the same as the whole length of the word line formed by the N type epitaxial layer 2. However, no $N^+$ type region is formed immediately beneath the memory cell. In accordance with this structure, the $N^+$ type region 12 reduces the equivalent resistance of the N type epitaxial layer 2 along the direction of the word line. Also, since there is no $N^+$ type region immediately beneath the memory cell, the greater portion $(1 — 1/\beta)$ of the current for writing-in the information passes effectively to the P type silicon substrate 1.

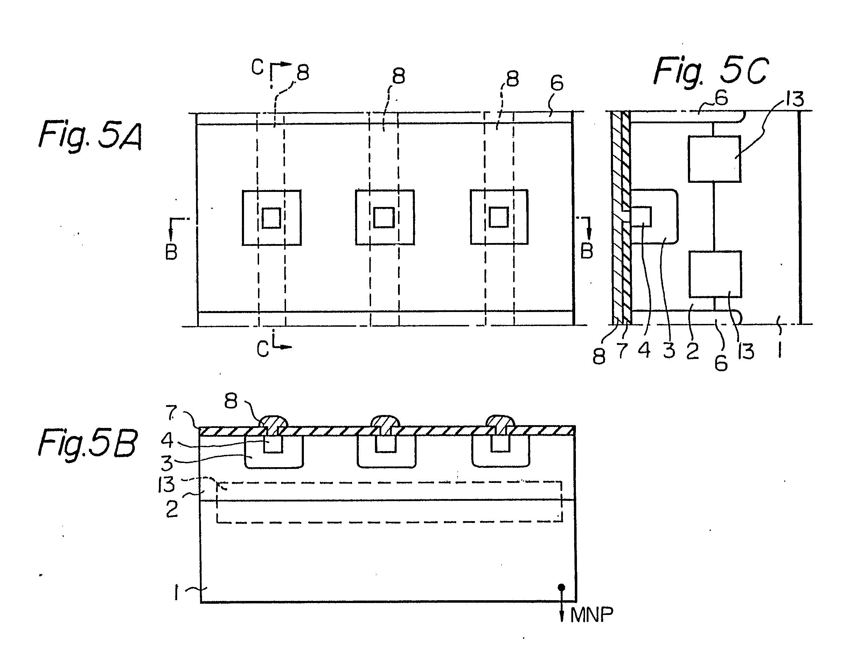

The third example in accordance with this invention is illustrated in Figures 5A, 5B, and 5C. In the third example an $N^+$ type region 13 which corresponds to the $N^+$ type region 11 in the first example is formed in the border between the N type epitaxial layer 2 and the P type silicon semiconductor substrate 1. The $N^+$ type region is formed between the memory cell region and the isolation region 6 and has its length the same as the whole length of the word line formed by the N type epitaxial layer 2. No $N^+$ type region is formed immediately beneath the memory cell region. In accordance with this structure, the $N^+$ type region 13 reduces the equivalent resistance of the N type epitaxial layer 2 along the direction of the word line. Also, since there is no $N^+$ type region immediately beneath the memory cell, the greater portion $(1 — 1/\beta)$ of the current for writing-in the information passes effectively to the P type silicon substrate 1.

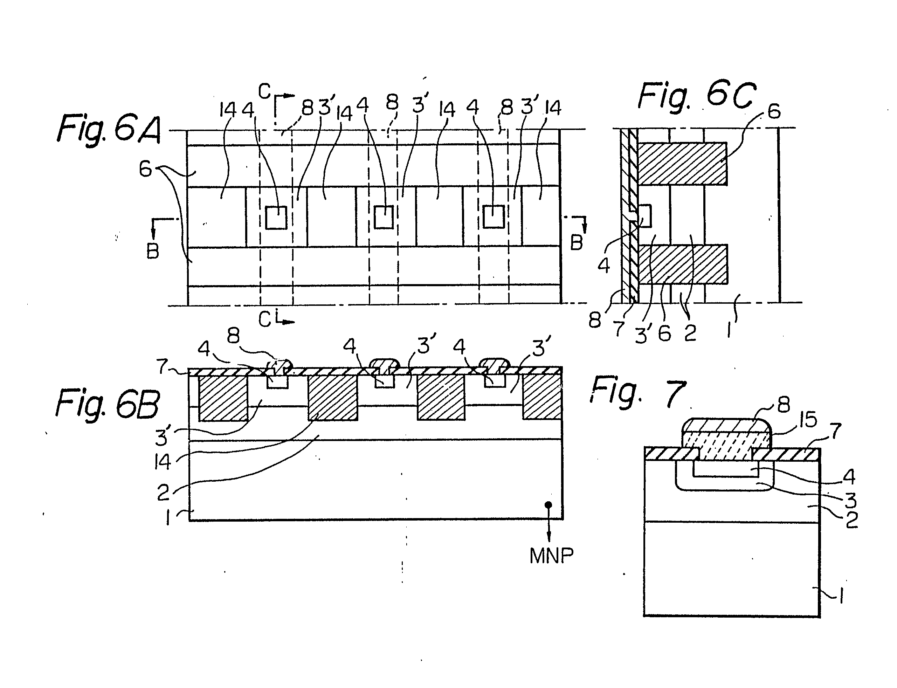

Another example of a prior art device is illustrated in Figures 6A, 6B and 6C. In this example a P type layer 3' is formed on the N type epitaxial layer 2 by an epitaxial growth process and the isolation region 14 of the insulating material is formed from the surface of said P type epitaxial layer 3' to a predetermined depth in the N type epitaxial layer 2 so that a plurality of the P type epitaxial layer 3' are separate like islands. The isolation region 6 of insulating material which separates the adjacent word line is formed from the surface of the P type epitaxial layer 3' through the N type epitaxial layer 2 to the P type silicon semiconductor substrate 1. A plurality of the memory cells in one word line are separated by the isolation regions 14 of insulating material. The structure shown in Figures 6A, 6B and 6C enables the thickness and the impurity concentration of the P type epitaxial layer 3' to be easily controlled and this is advantageous particularly for forming a junction having small depth.

A modification of the structure is shown in Figure 7 as applied to the prior art example described with reference to Figures 2A, 2B and 2C. In the memory device shown in Figure 7, a polycrystalline semiconductor layer 15 of, for example, polycrystalline silicon is formed between the N type region 4 and the bit line connecting conductor 8. Since, in the case where the heat treatment is effected after the formation of the connecting conductor 8 in the process of producing the memory device, it is possible that the inter-metal compounds, which are produced by the reaction between the material of the connecting conductor and the semiconductor layer, can penetrate like a spike through the PN junction and break down the PN junction so that an undesirable information storing status is formed, this polycrystalline semiconductor layer 15 plays a role in preventing such an undesirable phenomena.

With regard to the formation of the isolation regions in the above described embodiments which are formed from the surface of the epitaxial layer to the P type silicon semiconductor substrate and which define the word line region, said isolation regions may be formed either by the well known structure due to the impurity of diffusion or by the well known V-groove structure. The V-groove structure is especially suitable for high integration of the memory device, because the V-groove structure needs only a small space. The above-mentioned isolation layer is formed simultaneously with the formation of the isolation layer in the control circuit of the memory cell, which is also formed in the memory device chip for said memory cell. The $N^+$ type region 12, 13, said $N^+$ type region may be formed by means of the buried layer forming method for the bipolar integrated circuit.

With regard to the type of the transistor used in the memory cell, it is possible to use the NPN type transistors provided that the conduction types of the semiconductor substrate, the epitaxial layer and the like are opposite, respectively, to those in the above described embodiments. In this device, however, the control circuit for the memory cell formed in the epitaxial layer having an N type is formed by PNP type transistors. Since the operating speed of said control circuit is low, this device is disadvantageous for the realization of the high speed operation. Also this device is disadvantageous because a parasitic NPN type transistor consisting of the N type semiconductor substrate, the P type epitaxial layer and the N type region is formed when said PNP type transistor operates, because the semiconductor substrate having an N type is caused to become most positive, and meaningless current passes from the N type semiconductor substrate to said PNP type transistor so that extra power is required.

Also, it is possible to form a structure in which the base of said NPN type transistor is used as a word line, a diode is connected between the collector (or emitter) and a bit line, and the emitter (or collector) is grounded. However, in this structure, a portion of the current, which passes to the word line of the writing-in current from the bit line and word line to the selected memory cell during the writing-in of the information, leaks from the base of the NPN type transistor of the memory cell which is not selected to the emitter, in case where a diode is connected between the collector and the bit line and the emitter is grounded. Accordingly, a greater ability is required for the circuit for the writing-in current connected to said word line. Therefore, both a circuit for the writing-in current and a circuit for controlling the reading-out the information are necessary as the circuits connected to said word line. However, this causes a reduction of the degree of integration and the operating speed of this semiconductor memory device. In case where a diode is connected between the emitter of said NPN transistor and the bit line, it is necessary to maintain the collector in the most positive potential. This makes the structure of the control circuit for memory cell complicated and causes a meaningless current due to the parasitic transistor as described hereinbefore. In addition, the circuit for writing-in current connected to the word line is different from the circuit for controlling the reading-out the information. Accordingly, this also causes an increase of the number of semiconductor elements forming the circuit and reduction of the degree of integration and the operating speed of this semiconductor memory device.

Accordingly, it should be noted that these disadvantages do not occur in the aforementioned embodiments of the present invention using PNP type transistors.

**Claims**

1. A semiconductor memory comprising a P type semiconductor substrate (1), a word line (W1, W2) including an N type layer (2) having a portion contacting directly the P type substrate (1) to form an NP junction and including an $N^+$ type region (11, 12, 13) to reduce the resistance of the word line (2), a number of P type regions (3) formed on the surface of the N type layer (2), N type regions (4) formed in the P type regions (3), and a connecting conductor layer (8) which is connected to the N type regions (4) and which is used as a bit line ($B_1, B_2, \ldots B_N$) the P type regions (3) and the N type regions (4) forming information storing elements (DM), characterised in that the portion of the N type layer (2), contacting directly the P type substrate (1), is directly under the P type region (3), the P type substrate (1), the N type layer (2) and the P type regions (3) form vertical PNP type transistors (TRM), and the P type semiconductor substrate (1) is used as a collector common to the vertical PNP type transistors (TRM) having their emitters formed by the P type regions (3).

2. A semiconductor memory according to claim 1, wherein the $N^+$ type layer (11) is formed on the surface of the N type layer (2) along the direction of the sequence of the memory cells.

3. A semiconductor memory according to claim 1, wherein the $N^+$ type layer (12, 13) is formed on the border between the P type semiconductor substrate (1) and the N type layer (2) along the direction of the sequence of the memory cells.

**Patentansprüche**

1. Halbleiter-Speichervorrichtung mit einem P-Typ-Halbleitersubstrat (1), einer Wortleitung (W1, W2), die eine N-Typ-Schicht (2) einschließt, welche einen Abschnitt hat, der direkt das P-Typ-Substrat (1) kontaktiert, um einen N-P-Übergang zu bilden, und die einen $N^+$-Typ-Bereich (11, 12, 13) einschließt, um den Widerstand der Wortleitung (2) zu reduzieren, einer Anzahl von P-Typ-Bereichen (3), die auf der Oberfläche der N-Typ-Schicht (2) gebildet sind, N-Typ-Bereichen (4), die auf den P-Typ-Bereichen (3) gebildet sind, und einer verbindenden Halbleiterschicht (8), welche mit dem N-Typ-Bereichen (4) verbunden ist und welche als eine Bitleitung ($B_1$, $B_2$, ...$B_N$) verwendet wird, wobei die P-Typ-Bereiche (3) und die N-Typ-Bereiche (4) Information speichernde Elemente (DM) bilden, dadurch gekennzeichnet, daß der Abschnitt der N-Typ-Schicht (2), welcher direkt das P-Typ-Substrat (1) kontaktiert, direkt unter dem P-Typ-Bereich (3) ist, das P-Typ-Substrat (1), die N-Typ-Schicht (2) und die P-Typ-Bereiche (3) vertikale PNP-Typ-Transistoren (TRM) bilden, und das P-Typ-Halbleitersubstrat (1) als ein Kollektor verwendet wird, der den vertikalen PNP-Typ-Transistoren (TRM) gemeinsam ist, deren Emitter durch die P-Typ-Bereiche (3) gebildet werden.

2. Halbleiter-Speichervorrichtung nach Anspruch 1, bei welcher die $N^+$-Typ-Schicht (11) auf der Oberfläche der N-Typ-Schicht (2) längs der Richtung der Folge der Speicherzellen gebildet ist.

3. Halbleiter-Speichervorrichtung nach Anspruch 1, bei welcher die $N^+$-Typ-Schicht (12, 13) auf der Grenze zwischen dem P-Typ-Halbleitersubstrat (1) und der N-Typ-Schicht (2) längs der Richtung der Folge von Speicherzellen gebilder ist.

**Revendications**

1. Mémoire à semi-conducteurs comportant un substrat semi-conducteur (1) de type P, une ligne de mot (W1, W2) comprenant une couche (2) de type N avec une partie en contact direct avec le substrat (1) de type P pour former une jonction NP et comprenant une région (11, 12, 13) de type $N^+$ pour réduire la résistance de la ligne de mot (2), un certain nombre de régions (3) de type P formées sur la surface de la couche (2) de type N, des régions (4) de type N formées das les régions (3) de type P et une couche de conducteur de connexion (8) qui est connectée aux régions (4) de type N et qui est utilisée comme un ligne de bits (P1, P2, ...) et N, les régions (3) de type P et les régions (4) de type N formant des éléments de mémorisation d'informations (DM), caractérisée en ce que la partie de la couche (2) de type N en contact direct avec le substrat (1) de type P se trouve directement au-dessous dela région (3) de type P, le substrat (1) de type P, la couche (2) de type N et les régions (3) de type P formant des transistors verticaux (TRM) de type PNP et le substrat semi-conducteur (1) de type P étant utilisé comme un collecteur commun aux transistors verticaux TRM de type PNP dont les émetteurs sont formés par les régions (3) de type P.

2. Mémoire à semi-conducteurs selon la revendication 1, dans laquelle la couche (11) de type $N^+$ est formée sur la surface de la couche (2) de type N suivant la direction de la séquence des cellules de mémoire.

3. Mémoire à semi-conducteurs selon la revendication 1, dans laquelle la couche (12, 13) de type $N^+$ est formée sur la limite entre le substrat semi-conducteur (1) de type P et la couche (2) de type N suivant la direction de la séquence des cellules de mémoire.

0 008 946

*Fig. IA*

*Fig. IB*

1

*Fig. 2C*

*Fig.2A*

*Fig.2B*

# Fig. 3A

C

8  4  3                                6

11

B                                      B

11

C

# Fig. 3B

8  4  3

7

11

2

1

MNP

# Fig. 3C

11      6

3

4

2

11   6   1

0 008 946

Fig. 4A

Fig. 4B

Fig. 4C

0 008 946

Fig. 5A

Fig. 5B

Fig. 5C

0 008 946

Fig. 6A

Fig. 6C

Fig. 6B

Fig. 7

MNP

0 008 946